# EUROPÄISCHE PATENTANMELDUNG

(11) **EP 2 073 387 A2**
(43) Veröffentlichungstag der Anmeldung: **24.06.2009**
(21) Anmeldenummer: 08106004.8
(22) Anmeldetag: 17.12.2008
(51) Int. Cl.: H03K 17/96

(54) **Verfahren zur Herstellung eines tastenlosen Bediengeräts**

(30) Priorität: 20.12.2007 DE 102007061533
(71) Anmelder: Continental Automotive GmbH, 30165 Hannover (DE)
(72) Erfinder: Bolte, Peter Dr., 35418 Buseck (DE); Fiegler, Till, 35510 Butzbach / Maibach (DE); Heimberger, Hans-Dieter, 61440 Oberursel (DE); Reuter, Siegfried, 35510 Butzbach (DE); Santarossa, Bruno, 72227 Egenhausen (DE); Werner, Josef, 61389 Schmitten/Dorfweil (DE)

(57) **Zusammenfassung**

Mit einem Verfahren zur Herstellung eines tastenlosen Bediengerätes (1), insbesondere zur Verwendung im Armaturenbereich eines Kraftfahrzeugs soll auf eine Trägerfolie (4) einerseits eine Bedruckung und andererseits eine piezoelektrische Schicht (6) aufgebracht werden, wobei anschließend die Trägerfolie (4) einer 3D-Verformung unterzogen wird. Dazu werden erfindungsgemäß auf vergleichsweise einfache und günstige Weise ein in seiner Formgebung besonders flexibel an ein vorgegebenes Innenraumdesign anpassbares und vergleichsweise langlebiges und haltbares Bedienelement (1) erhältlich.

## Beschreibung

Die Erfindung bezieht sich auf ein Verfahren zur Herstellung eines tastenlosen Bediengeräts, insbesondere zur Verwendung im Armaturenbereich eines Kraftfahrzeugs.

Bediengeräte oder -elemente werden in vielfältiger Form bei elektronischen Geräten verwendet, insbesondere im Armaturenbereich oder im Cockpit eines Kraftfahrzeugs. Derartige Geräte kommen dabei insbesondere für Kraftfahrzeugklimaanlage oder -audiogeräte zum Einsatz. Zur Aktivierung einzelner Funktionen werden dabei üblicherweise berührungsempfindliche Elemente wie beispielsweise Tasten eingesetzt, deren Betätigung durch den Nutzer oder Fahrer ein nachgelagertes elektrisches oder elektronisches Element aktiviert. Im Rahmen komplexerer Anlagen können die Bediengeräte oder -elemente dabei zusätzlich auch mit Anzeigeelementen, bei denen geeignete Symbole auf die entsprechenden Funktionen verweisen, kombiniert oder versehen sein.

Grundsätzlich besteht bei derartigen Bedienelementen oder -geräten das Bestreben, sie sowohl in optischer als auch in funktionaler Hinsicht und auch im Hinblick auf die tastbaren Berühreigenschaften möglichst harmonisch in die Cockpitgestaltung insgesamt und in das Innenraumdesign des Kraftfahrzeugs zu integrieren. Dabei kann es insbesondere auch wünschenswert sein, derartige Bedienelemente hinsichtlich ihrer Oberfläche konturiert auszuführen und den allgemeinen Oberflächenverlauf des Cockpits oder Armaturenbretts im Bereich ihrer jeweiligen Positionierung anzupassen. Im Allgemeinen werden dazu die Bedien- oder Anzeigeelemente in einem Kraftfahrzeug-Cockpit im Kunststoff-Spritzgussverfahren hergestellt.

Der Erfindung liegt nunmehr die Aufgabe zugrunde, ein Verfahren zur Herstellung eines Bediengerätes oder -elements der oben genannten Art anzugeben, mit dem auf vergleichsweise einfache und günstige Weise ein in seiner Formgebung besonders flexibel an ein vorgegebenes Innenraumdesign anpassbares und vergleichsweise langlebiges und haltbares Bedienelement erhältlich ist.

Diese Aufgabe wird erfindungsgemäß gelöst, indem auf eine Trägerfolie einerseits eine Bedruckung und andererseits eine piezoelektrische Schicht aufgebracht werden, wobei anschließend die Trägerfolie einer 3D-Verformung unterzogen wird.

Die Erfindung geht dabei von der Überlegung aus, dass eine besonders lange Lebensdauer des Bedienelements erreichbar ist, indem dieses als tastenloses Bediengerät, insbesondere unter Rückgriff auf piezoelektrische Sensoren oder Fühler ausgeführt wird. Derartige Bedieneinheiten mit Piezosensoren kommen in planarer Ausführung beispielsweise im Bereich der Haushaltselektronik zum Einsatz. Ein Haushaltsgerät mit einer derartigen Bedieneinheit ist beispielsweise aus der DE 198 11 372 A1 bekannt.

Um ein derartiges Element grundsätzlich im Bereich der Bediengeräte für Kraftfahrzeug-Armaturen einsetzbar zu machen, sollte aber von der Randbedingung einer planaren Ausführung des Bedienelements abgewichen werden. Dies ist unter Rückgriff auf die piezoelektrische Sensorentechnik möglich, indem als Basiskörper zur Aufbringung einer piezoelektrischen Beschichtung eine an sich verformbare Trägerfolie verwendet wird, die zunächst mit einer Bedruckung zur Herstellung des gewünschten Dekors versehen wird. Auf diese kann die piezoelektrische Schicht in geeigneter Form aufgebracht werden, wobei anschließend eine geeignete dreidimensionale Verformung ("3D-Verformung") der mit der Schicht versehenen Trägerfolie vorgenommen wird. Auf diese Weise ist erreicht, dass selbst bei der Herstellung von gewölbten Oberflächen eine gleich bleibend funktionale und somit als Berührungssensor nutzbare piezoelektrische Schicht in sämtlichen Oberflächenbereichen beibehalten werden kann.

Die piezoelektrische Schicht kann dabei in einer zur Handhabung der piezoelektrischen Materialien geeigneten Weise aufgebracht werden. Vorteilhafterweise wird dazu nach dem Bedrucken der Trägerfolie ein piezoelektrischer Druckaufbau aufgebracht, wobei die 3D-Verformung des Foliensystems nach der piezoelektrischen Polarisierung vorgenommen wird. In alternativer vorteilhafter Ausgestaltung wird nach dem Bedrucken der Trägerfolie eine piezoelektrisch bedruckte, polarisierte Folie auflaminiert.

Um die Einsetzbarkeit im Bereich der Kraftfahrzeug-Armaturen noch weiter zu begünstigen, ist in vorteilhafter Weiterbildung eine Möglichkeit zur gezielten Ausleuchtung von Symbolen oder dergleichen vorgesehen. Um dies zu ermöglichen, wird vorteilhafterweise der vorgesehene Mehrschichtaufbau mit geeigneten Beleuchtungsmitteln versehen. Dazu wird zweckmäßigerweise zwischen der Bedruckung und der piezoelektrischen Schicht ein Lichtverteilelement angeordnet. Dabei kann insbesondere eine Lichtverteilfolie, vorzugsweise mit integrierten Lichtleitkanälen, zwischen die Dekor- oder Trägerfolie und die Piezofolie laminiert oder eine geeignete Platte zur Lichtverteilung zwischen den beiden Folien spritzgegossen oder verklebt werden. In alternativer oder zusätzlicher vorteilhafter Ausgestaltung ist zur Bereitstellung eines geeigneten Beleuchtungssystems ein Elektrolumineszenz-Aufbau der Träger- oder Dekorfolie zugeordnet. Dazu wird vorteilhafterweise zwischen der Bedruckung und der piezoelektrischen Schicht ein Elektrolumineszenz-Aufbau angebracht.

Die 3D-Verformung der mit der piezoelektrischen Schicht versehenen Trägerfolie kann durch geeignete Methoden, vorzugsweise durch Tiefziehen oder Hochdruckverformen oder auch in einem Spritzgießwerkzeug, vorgenommen werden.

Vorteilhafterweise wird zur Herstellung eines besonders formstabilen und widerstandsfähigen Elements die bedruckte, mit der piezoelektrischen Schicht versehene Trägerfolie nach ihrer 3D-Verformung hinterspritzt, vorzugsweise mit einem geeignet gewählten Kunststoff. Die Hinterspritzung kann dabei in einem gemeinsamen Arbeitsschritt mit der 3D-Verformung des Foliensystems erfolgen, wenn diese im Spritzgießwerkzeug vorgenommen wird. Im Übrigen kann die Hinterspritzung unter Rückgriff auf Standard-Technologien vorgenommen werden, wobei 3D-verformte hinterspritzte Folien in Klimabediengeräten bereits als Standarddekor verwendet werden.

Die mit der Erfindung erzielten Vorteile bestehen insbesondere darin, dass durch die 3D-Verformung der mit der piezoelektrischen Schicht versehenen Trägerfolie eine im Wesentlichen frei wählbare Oberflächenkontur für das Bedienelement oder -gerät hergestellt werden kann, ohne dass in den jeweiligen Oberflächenbereichen die Funktionalitäten der Berührungssensoren beeinträchtigt werden. Damit ist eine weit gehend freie Gestaltung und Platzierung individueller Bedienelemente oder Tastenfunktionen auf dem solchermaßen hergestellten Formteil ermöglicht. Durch die tastenlose Ausführung des jeweiligen Bediengeräts unter Rückgriff auf die piezoelektrische Beschichtung ist zudem bei vergleichsweise freier Verformbarkeit eine besonders lange Haltbarkeit und Lebensdauer des Bedienelements gewährleistet.

Ein Ausführungsbeispiel der Erfindung wird anhand einer Zeichnung näher erläutert. Darin zeigen:
- FIG 1: ein Bediengerät einer Klimaanlage in einem Kraftfahrzeug, und
- FIG 2: das Bediengerät nach FIG 1 im Querschnitt.

Gleiche Teile sind in beiden Figuren mit denselben Bezugszeichen versehen.

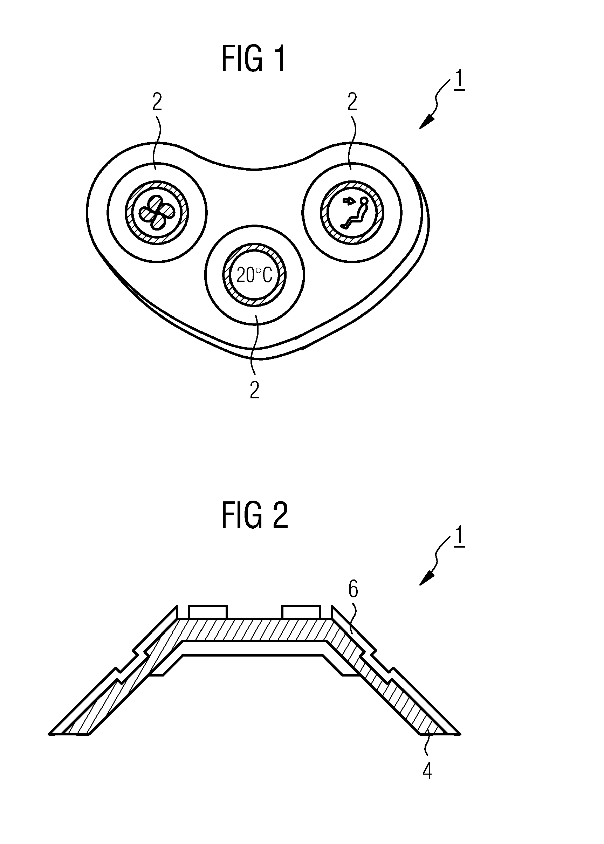

Das in FIG 1 schematisiert dargestellte Bediengerät 1 einer Fahrzeug-Klimaanlage gemäß weist eine Anzahl von im Ausführungsbeispiel als Drehsteller ausgeführten Bedienelementen 2 auf. Das Bediengerät 1 ist zum Einbau in ein Fahrzeugcockpit vorgesehen, wobei die Konturierung der Oberflächen an das gewünschte Innenraumdesign des Cockpits angepasst ist. Auch die Bedienelemente 2 sowie gegebenenfalls weitere, nicht näher dargestellte Bedienelemente oder Anzeigeelemente sind dabei hinsichtlich ihrer Größe, Form und Konturierung an das gewünschte Innenraumdesign angepasst.

Um die dazu erforderliche, nahezu frei entsprechend den Vorgaben des Innenraumdesigns wählbare Formgebung des Bediengeräts 1 zu ermöglichen, ist dieses im Wesentlichen auf der Basis einer dreidimensional verformten Trägerfolie hergestellt. Wie im Querschnitt gemäß FIG 2 erkennbar, ist dabei als Basiselement oder Basiskörper eine Trägerfolie 4 vorgesehen, die mit einer piezoelektrischen Schicht 6 versehen ist.

Zur Herstellung des Bediengeräts 1 wird auf die Trägerfolie 4 zunächst eine geeignete Bedruckung aufgebracht, die die optische Gestaltung des herzustellenden Formteils gemäß den Vorgaben des Innenraumdesigns gewährleisten soll. Auf die solchermaßen bedruckte Trägerfolie 4 wird anschließend die piezoelektrische Schicht geeignet aufgebracht, wobei beispielsweise ein piezoelektrischer Druckaufbau mit nachfolgender piezoelektrischer Polarisierung oder alternativ auch die Auflaminierung einer piezoelektrisch bedruckten, polarisierten Folie vorgesehen sein kann. Nach der Herstellung dieses Verbundsystems oder der beschichteten Trägerfolie 4 wird diese einem geeigneten dreidimensionalen Verformungsschritt ("3D-Verformung") unterzogen.

Dazu kann beispielsweise ein geeignetes Tiefziehverfahren oder auch eine Hochdruckverformung vorgesehen sein. Alternativ kann auch die Verformung in einem Spritzgießwerkzeug vorgesehen sein.

Anschließend wird das solchermaßen hergestellte, nunmehr dreidimensional entsprechend der gewünschten Oberflächenkontur ausgestaltete Formteil mit einer geeigneten Hinterspritzung versehen, um die gewünschte Stabilität zu gewährleisten.

## Patentansprüche

1. Verfahren zur Herstellung eines tastenlosen Bediengerätes (1), insbesondere zur Verwendung im Armaturenbereich eines Kraftfahrzeugs, bei dem auf eine Trägerfolie (4) einerseits eine Bedruckung und andererseits eine piezoelektrische Schicht (6) aufgebracht werden, wobei anschließend die Trägerfolie (4) einer 3D-Verformung unterzogen wird.

2. Verfahren nach Anspruch 1, bei dem nach dem Bedrucken der Trägerfolie (4) ein piezoelektrischer Druckaufbau aufgebracht wird, wobei die 3D-Verformung nach der piezoelektrischen Polarisierung vorgenommen wird.

3. Verfahren nach Anspruch 1, bei dem nach dem Bedrucken der Trägerfolie (4) eine piezoelektrisch bedruckte, polarisierte Folie auflaminiert wird.

4. Verfahren nach einem der Ansprüche 1 bis 3, bei dem zwischen der Bedruckung und der piezoelektrischen Schicht (6) ein Lichtverteilelement angeordnet wird.

5. Verfahren nach einem der Ansprüche 1 bis 4, bei dem zwischen der Bedruckung und der piezoelektrischen Schicht (6) ein Elektrolumineszenz-Aufbau angebracht wird.

6. Verfahren nach einem der Ansprüche 1 bis 5, bei dem die 3D-Verformung in einem Tiefziehvorgang vorgenommen wird.

7. Verfahren nach einem der Ansprüche 1 bis 6, bei dem die 3D-Verformung in einem Spritzgießwerkzeug vorgenommen wird.

8. Verfahren nach einem der Ansprüche 1 bis 7, bei dem die bedruckte, mit der piezoelektrischen Schicht versehene Trägerfolie (4) nach ihrer 3D-Verformung hinterspritzt wird.
